Europäisches Patentamt

European Patent Office

Office européen des brevets

(11) Publication number: **0 223 198 B1**

## EUROPEAN PATENT SPECIFICATION

(45) Date of publication of patent specification: **29.07.92**　(51) Int. Cl.⁵: **B26F 3/00**, H05K 3/00

(21) Application number: **86115734.5**

(22) Date of filing: **12.11.86**

(54) Apparatus for peeling a film stuck on a board.

(30) Priority: **12.11.85 JP 253434/85**
**27.11.85 JP 266490/85**
**05.02.86 JP 23179/86**

(43) Date of publication of application:
**27.05.87 Bulletin 87/22**

(45) Publication of the grant of the patent:
**29.07.92 Bulletin 92/31**

(84) Designated Contracting States:
**DE FR GB IT**

(56) References cited:
**EP-A- 0 028 056      EP-A- 0 117 231**
**DE-A- 2 634 413      DE-A- 2 751 862**
**DE-A- 3 402 009      FR-A- 2 438 252**
**GB-A- 1 291 662      GB-A- 2 137 597**
**JP-A-58 091 782      US-A- 4 042 880**

**PATENT ABSTRACTS OF JAPAN, vol. 9, no. 6
(P-326)[1729], 11th January 1985; & JP-A-59
154 447 (HITACHI KASEI KOGYO K.K.)
03-09-1984**

(73) Proprietor: **SOMAR CORPORATION**
**11-2, Ginza 4-chome Chuo-ku**
**Tokyo 104(JP)**

(72) Inventor: **Sumi, Shigeo**
**8-11, Ayase**
**Hasuda-shi Saitama(JP)**

(74) Representative: **Boeters, Hans Dietrich, Dr. et
al**
**Bereiteranger 15**
**W-8000 München 90(DE)**

## Description

This invention relates to a film peeling apparatus as specified in the preamble of claim 1.

Printed circuit boards for use in electronic equipment such as computers are provided with a predetermined copper wiring pattern formed on one or both sides of insulating boards.

A printed circuit board of that sort is manufactured by the steps comprising laminating a photosensitive resin layer (photoresist) and a translucent resin film (protective film) for protecting the photosensitive resin layer on a conductive layer laid on an insulating substrate through thermocompression bonding; superposing a film having a wiring pattern; exposing the photosensitive resin layer to light for a fixed period of time through the film having the wiring pattern and the translucent resin film; developing the thus exposed photosensitive resin layer after peeling off the translucent resin film to form an etching mask pattern; removing unnecessary portions of the conductive layer by etching; and further removing the remaining photosensitive resin layer. A printed circuit board having a predtermined wiring pattern is thus prepared.

During the above steps of manufacturing a printed circuit board, the translucent resin film must be peeled off when the photosensitive resin layer is developed after being exposed to light. That step of peeling off the translucent resin film until recently relied on manual work, which requires a clever-fingered worker as well as an extremely skilled hand to prevent damage and breakdown attributed to unevenly distributed peel stress as the film is thin. The problem is that lengthy work is required in the manufacture of a printed circuit board because it takes time to peel off the translucent resin film.

The document DE-A-27 51 862 discloses an automatic film peeling apparatus of the kind mentioned above in which, upon detecting the advance end of the film on a board or the like, the film is lifted and separated by applying mechanical energy in the form of pressure and friction through rotary brushes. Though in many cases this apparatus renders satisfactory results, it is still desirable to obtain improved reliability of operation where the film to be peeled off is relatively stiff or sticks to its underground very firmly.

The document GB-A-2 137 597 discloses an apparatus applying mechanical pressure to a web of overlapping sheets, such as book covers, jointly laminated with a protective plastic layer for separation of the individual sheets. The pressure is applied in two steps including a tear initiation step and a separation step.

On this background the invention as claimed aims at improving an apparatus of the kind described in the preamble of claim 1 so that a film stuck on a board is peeled off very reliably in a continuous automatic manner. This is achieved by the characterizing features of claim 1. Advantageous further developments are laid down in the dependent claims.

The retractable pointed elements of the present invention apply to the film to be peeled off a deformation which effects crimping of the film to a degree that it becomes locally separated from its underground such as an underlying photosensitve resin layer. The film thus separated can then be gripped and torn away easily such as by means principally known in the art. The underlying layer, though it might also be deformed by the pressure applied through the film to be peeled off, quite generally will recover from this deformation since it is more elastic and, moreover, its deformation will be less than that of the covering film to be peeled off.

In the following two preferred embodiments are described in detail in connection with the accompanying drawings in which:

Fig. 1 is a schematic side elevational view showing a protective film peeling apparatus in accordance with an embodiment of the invention;

Fig. 2 is a side elevational view showing a film lifting mechanism in accordance with the embodiment;

Figs. 3(a) and 3(b) are side elevational views showing a film lifting unit;

Fig. 4 is a plan view showing a positional relationship among an end of a pressing member, an end portion of a film end detecting member, and a tip end of a film lifting unit;

Fig. 5 is a perspective view showing a film end detecting mechanism and stops in accordance with the embodiment;

Fig. 6 is a schematic cross-sectional view showing film peeling and discharging mechanisms;

Figs. 7 and 8 are, respectively a schematic fragmentary perspective view and a side sectional view showing the film peeling and discharging mechanisms and a peeling angle setting member in accordance with the embodiment.

Fig. 9 is an enlarged traced side view of a principal portion of a film peeling apparatus in accordance with another embodiment of a film lifting mechanism;

Fig. 10 is a structural drawing of a pressing mechanism of Fig. 9;

Fig. 11 is an exploded view of Fig. 10;

Fig. 12 is a partial sectional view or Fig. 10;

Figs. 13 and 14 are sectional views of a principal portions of a printed circuit board of Fig. 9;

Fig. 15 is a perspective view showing a peeling angle setting plate of the second embodiment;

and

Fig. 16 is a fragmentary perspective view of a sensor unit in accordance with the present invention.

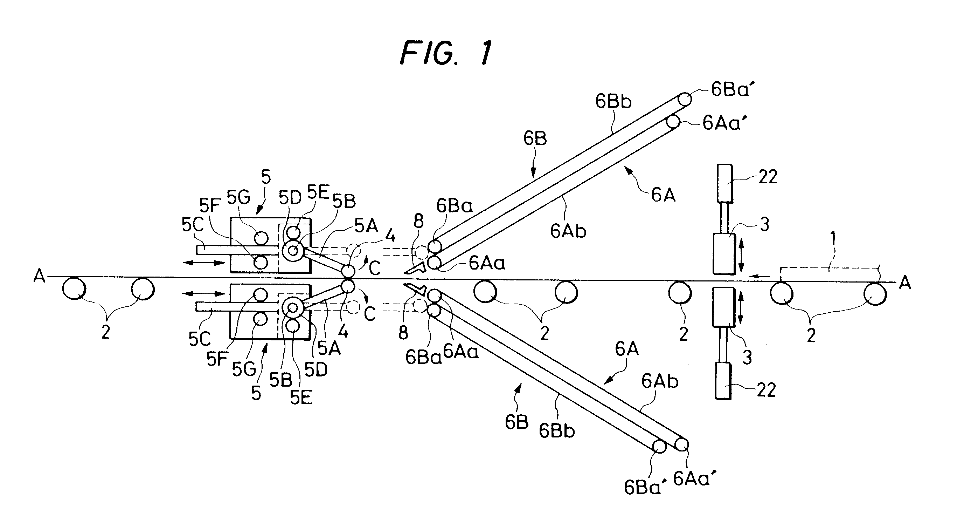

As shown in Fig. 1, a mechanism for conveying a printed circuit board 1 in a film peeling apparatus of the present invention comprises conveyor rollers 2 for carrying the printed circuit board 1. A film end lifting mechanism 3, adhesive members 4 mounted on movable arms of a film raising mechanism 5, and a film peeling angle setting member 8 are installed in the conveyance path of the conveyance mechanism.

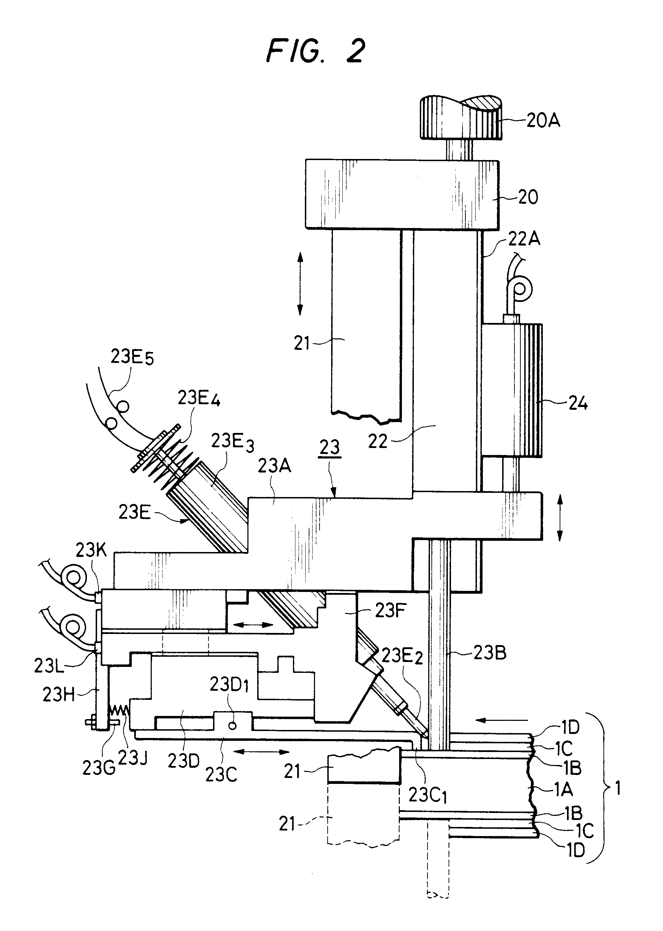

As shown in Fig. 2, the printed circuit board 1 is formed of conductive layers 1B of copper stuck to both sides (or one side) of an insulating substrate 1A. Laminated bodies, each consisting of a photosensitive resin layer 1C and a translucent (protective) resin film 1D, are stuck on the conductive layers 1B of the printed circuit board 1 through thermocompression bonding. The photosensitive resin layers 1C have already been exposed to light so as to form a predetermined pattern.

The conveyor rollers 2 are so arranged as to carry the printed circuit board 1 in the direction of the arrow depicted along the conveyance path A-A of Fig. 1.

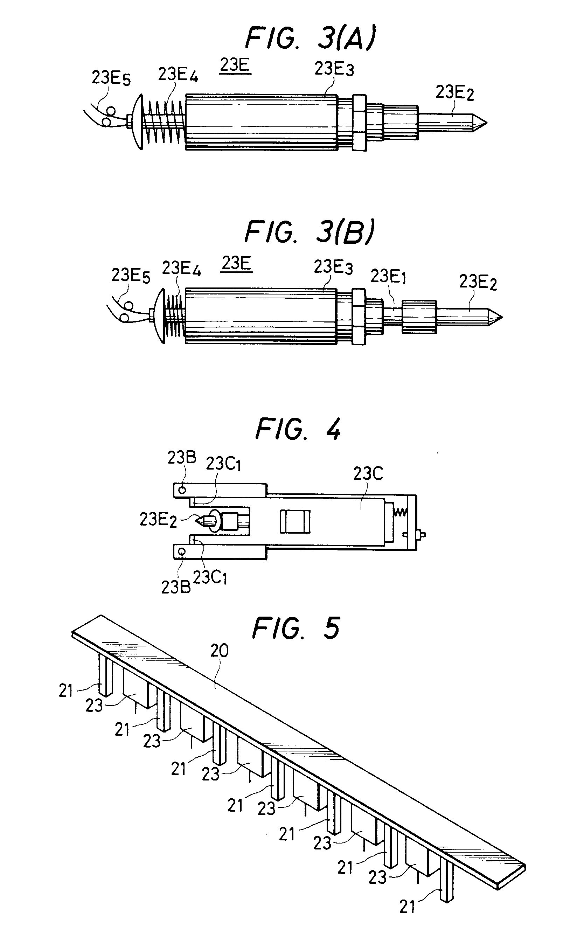

As shown in Fig. 5, in the film end lifting mechanism 3, a plurality of stops 21 for stopping the base 1 at a predetermined position are provided on a support frame 20 which is slidably mounted on the film peeling apparatus.

As shown in Figs. 2 a plurality of film end lifting unit support frames 22 are connected to the support frame 20. Each of the support frames 22 has a guide rail 22A along which a film end lifting unit 23 is moved up and down. The support frame 20 is adapted to be moved by, for example, an air cylinder 20A. The film end lifting unit 23 is slidably mounted through the support frame 23A to the guide rail 22A of the film end lifting unit support frame 22. Each film end lifting unit 23 is moved through a support frame 23A by the air cylinder 24 to be close to or remote from the board 1.

On the support frame 23A there are mounted pressing members 23B which serve to press the board that has been stopped by the stops 21 to correct curvature or warpage of the board. On the support frame 23A there are slidably mounted a film end detecting member support frame 23D supporting a film end detecting member 23C, and a film lifting member support frame 23F.

The film lifting member support frame 23F is slidably mounted on the film end detecting member support frame 23D. A film lifting member 23E is fixed to the distal end of the support frame 23F at a predetermined slant angle. A screw 23G for adjustment of movement of the film lifting member 23E is provided at a rear end of the support frame 23F through a frame 23H. A spring 23J is provided for urging the film lifting member support frame 23F rearwardly. The projecting length of the movement adjusting screw 23G adjusts a set distance between the film lifting member 23E and the end of the film 1D to be peeled.

An end of the film end detecting member 23C is bent downwardly and is bifurcated to define therein a U-shaped space. The film end detecting member 23C is rotatably supported at a fastening pin 23D1 to the film end detecting member support frame 23D.

The film lifting member 23E is composed of a vibrator as follows: Fig. 3A shows the lifting member 23E to which no electric power is supplied and Fig. 3B shows the lifting member to which electric power is supplied. A needle-like member 23E2 is provided at a movable end 23E1. When no electric power is supplied to an electromagnetic coil 23E3 as shown in Fig. 3A, the needle-like member 23E2 is retracted rearwardly by a spring 23E4. When electric power is supplied through cord 23E5 to the electromagnetic coil 23E3 as shown in Fig. 3B, the movable end 23E1 is repulsed to project the needle-like member 23E2 to thereby vibrate the needle-like member 23E2.

It is apparent that the film lifting member 23E is not limited to the above-described vibrator but a variety of vibrators such as a supersonic vibrator that vibrates by supersonic waves, a mechanical vibrator that vibrates by translating a rotational motion into a linear motion, or a fluid type vibrator that vibrates according to a fluid pressure may also be used.

As shown in Fig. 4, in non-operation, the distal end of the film end detecting member 23C and the distal end of the lifting member 23E are located at a retracted position from the pressing members 23B. During operation, these ends are projected somewhat from the position of the pressing members 23B.

The operation of the film end lifting unit 23 so far described will now briefly be explained;

In Fig. 2, when the support frame 20 is moved toward the conveyance path by the air cylinder 20A, the travelling board 1 is stopped by the stops 21. Subsequently the support frame 23A is moved toward the board conveyance path by an air cylinder 24, thereby applying a pressure to the board end. Thus warpage or curvature of the board 1 is corrected. Under this condition, the support frame 23D is moved rightward by an air cylinder 23K, so that the film end detecting member 23C is brought into contact with the light-sensitive resin layer 1C or the transparent protective resin film 1D. Under this condition, the support frame 23F is moved rightward by an air cylinder 23L, so that the needle-like member 23E2 of the film lifting unit 23E is activated. Then, vibrations are applied to the transparent resin film 1D so that it will be lifted away from the light-sensitive resin layer 1C.

As shown in Fig. 1, the adhesive members 4 are attached to rotational arms 5A of a film raising mechanism 5. Each rotational arm 5A is rotatable about a shaft 5B, so that it causes the adhesive member 4 to be pressed against the end portion of the transparent resin film 1D. The shaft 5B is supported by a support rod or rack 5C, so that, under the condition that the end of the adhesive member 4 is in contact with an upper face of the leading end portion of the transparent resin film 1D, the arm 5A of the film raising mechanism 5 is rotated in the direction C by gears 5D, 5E. By rightward moving operation of gears 5F, 5G and the rack 5C, the end portion of the transparent resin film 1D is raised, and the film 1D is carried to an inlet of a film peeling and discharging mechanism 6. The raised film 1D is clamped between rollers 6Aa and 6Ba. Thereafter, the rotational arm 5A is moved leftward, thereby separating the adhesive member 4 from the transparent resin film 1D.

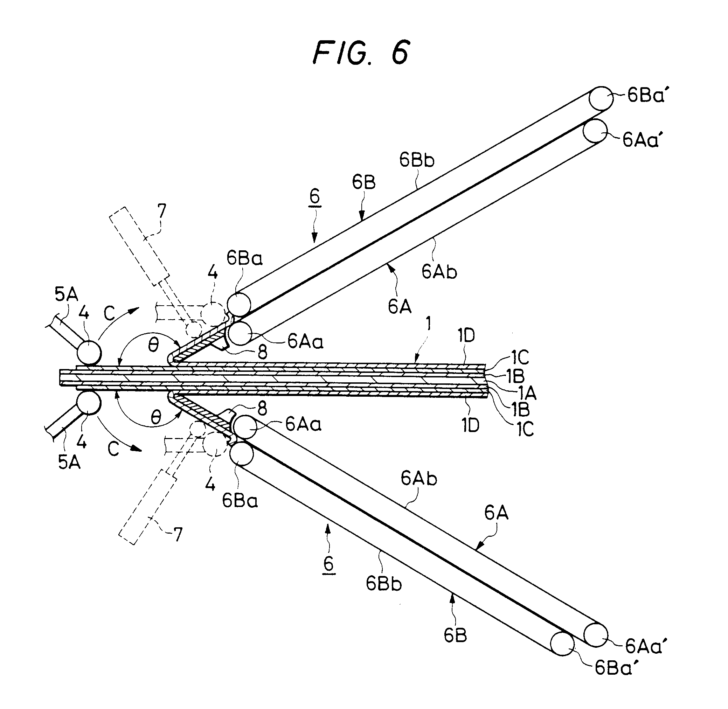

In order to ensure the separation between the adhesive member 4 and the transparent resin film 1D, as shown in Fig. 6, a film end pressing mechanism 7 may be used as shown by dotted lines in Fig. 6.

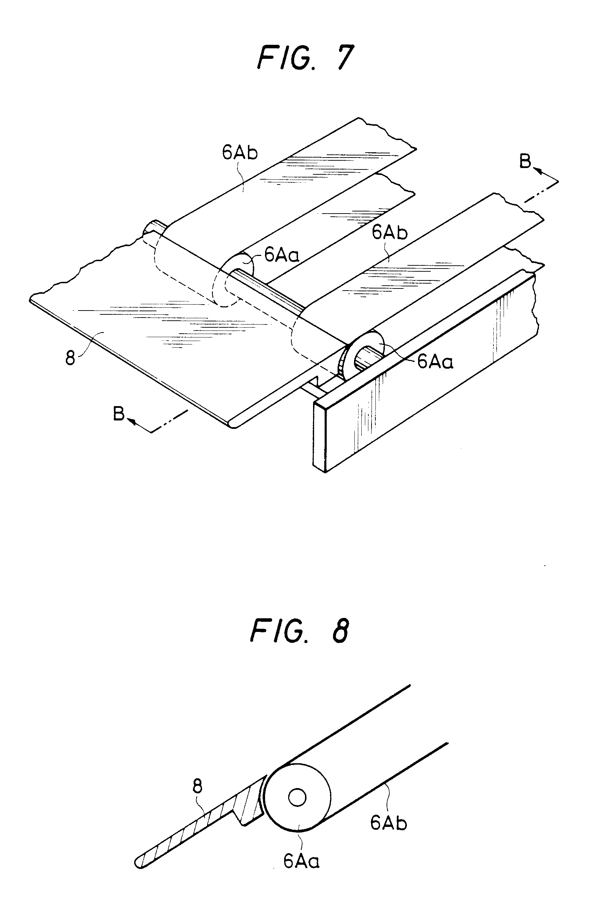

As shown in Figs. 6 to 8, the film peeling angle setting member 8 is provided in a box member of the peeling apparatus, so that it is aligned with a belt conveyor 6A of the film peeling and discharging mechanism 6.

In order to prevent displacement of the peeling position during the peeling action and the local application of the peeling stress and to prevent damage or failure of the transparent film 1D and the light-sensitive resin layer 1C, the peeling angle setting member 8 is constructed to allow setting of the peeling angle of the transparent resin film 1D. The peeling angle $\theta$ defined between the raised transparent resin film 1D and the printed circuit board 1 should not be smaller than a right angle. The peeling angle setting member 8 is constructed so that its front end is movable to be close to or away from the printed circuit board 1.

The end of the peeling angle setting member 8 has an arcuate shape defined by a short radius of curvature in cross-section. For example, the curvature radius is less than 3 mm.

The peeling and discharging mechanism 6 is composed of belt conveyors 6A and 6B. The belt conveyor 6A, as shown in Figs. 1 and 6, has a plurality of paired rollers 6Aa, 6Aa' and belts 6Ab entrained between the rollers 6Aa, 6Aa'. In the same manner, the belt conveyor 6B is composed of a pluralty of paired rollers 6Ba, 6Ba' and belts 6Bb entrained between the rollers 6Ba, 6Ba'.

The belt conveyor 6B may be rotated around the one-side rollers 6Ba' by a drive means such as an air cylinder and may be in contact with the belts 6Ab of the other belt conveyor 6A. In this case, the end portion of the transparent resin film 1D brought to the inlet of the peeling and discharging mechanism 6 may be clamped or moved for discharge without fail, thereby eliminating a possible discharge error of the film.

The transparent resin film 1D that has been peeled by the film raising mechanism 5 and guided by the film peeling angle setting member 8 is clamped between the belt conveyors 6A and 6B. By driving the respective paired rollers 6Aa, 6Aa' and 6Ba, 6Ba', the transparent resin films 1D are peeled and discharged one after another.

The belt conveyors 6A and 6B are located close to or in contact with each other in a staggered manner in the travelling direction, so that the peeled transparent resin film 1D is to be discharged from the roller 6Aa' side.

When the transparent resin film 1D is thus peeled, the printed circuit board 1 is delivered by the conveyance rollers 2 to a developing section where the light-sensitive resin layer 1C is to be developed.

In the foregoing embodiment, the film end lifting mechanism 3 is disposed upstream of the film peeling angle setting member 8. It is, however, possible to dispose the mechanism 3 between the film raising mechanism 5 and the film peeling angle setting member 8.

The foregoing embodiment of the invention is designed for peeling a protective film from printed circuit boards. However, the invention may also be applied to other peeling apparatus as, for example, apparatus for peeling films from decorative plates of building materials.

Also, instead of the adhesive members 4, it is possible to use a means for spraying fluid toward the lifted portion of the transparent resin film 1D.

As has been described above, according to the present invention, the end portion of the film 1D to be peeled is detected, and vibrations are applied to a portions having a predetermined length from the film end, thereby lifting this portion from the board 1. Thus, there is no danger that a circuit pattern on the board 1 would be damaged during the peeling operation.

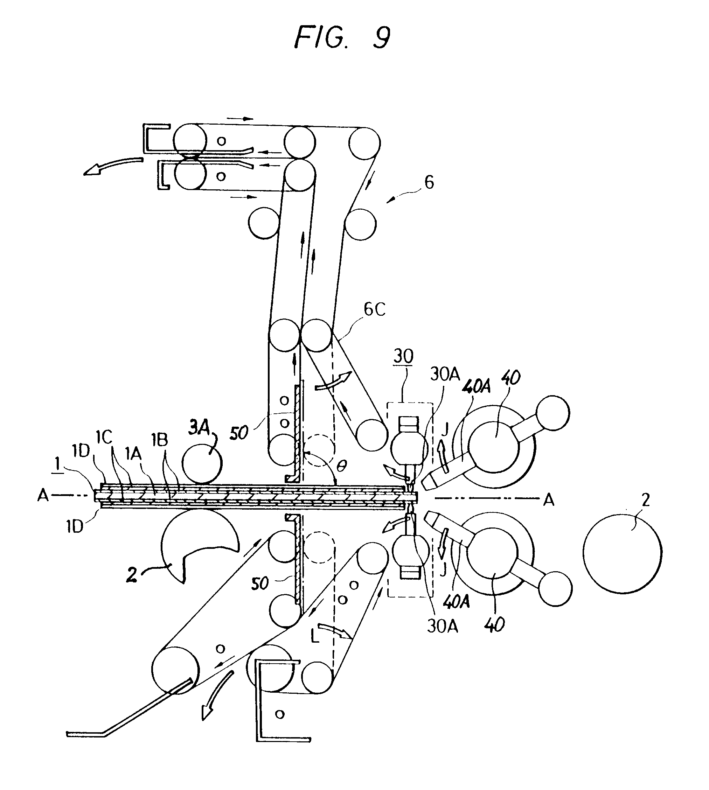

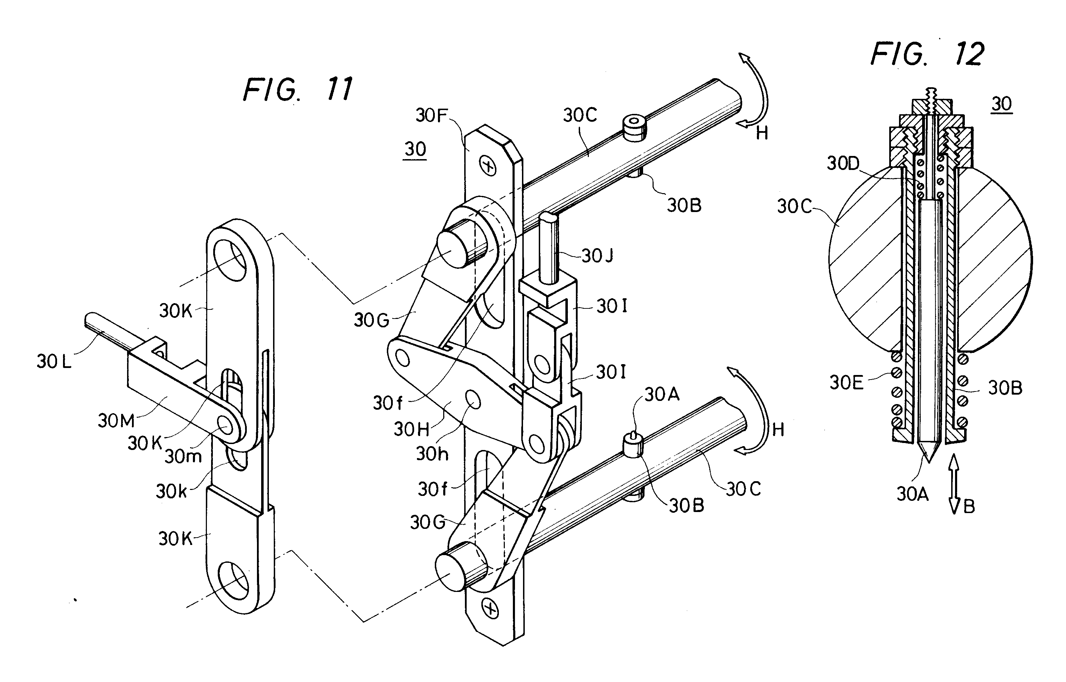

Figs. 9 to 14 show another embodiment of the invention in which, instead of the film lifting mechanism 3, of the foregoing example a pressing mechanism 30 is used which comprises a plurality of projecting press members 30A installed on both sides of the printed circuit boards 1, the projecting press members 30A being arranged across the conveyance direction (the transversal direction of the printed circuit boards 1). Each projecting press member 30A is needle-shaped as shown in Fig. 12 and formed so that the end of the laminated body composed of the photosensitive resin layer 1C and the translucent resin film 1D is pressed by the front end of the projecting press member 30A. The projecting press member 30A is also so arranged as not to bite into the interface between the conductive layer 1B and the photosensitive resin layer 1C when it presses the end of the laminated body and has an apex angle of, e.g., about 60 degrees to make the translucent resin film 1D peel off the photosensitive resin layer 1C. Each of the projecting press members 30A arranged opposite to each other is supported by a discrete rotary projecting press member supporting shaft 30C through a holder 30B. The holder 30B, which is supplied with a code, is installed in such a manner as to slide along a through-hole of the rotary shaft 30C.

The same or different elastic members 30D and 30E are installed between the projecting press member 30A and the holder 30B and between the holder 30B and the rotary shaft 30C, respectively. The elastic members 30D and 30E are installed in the direction of arrow B, i.e., in such a manner as to act on the printed circuit board 1. The position of the front end of the projecting press member 30A can be changed in the direction of the arrow B relative to the rotary shaft 30C.

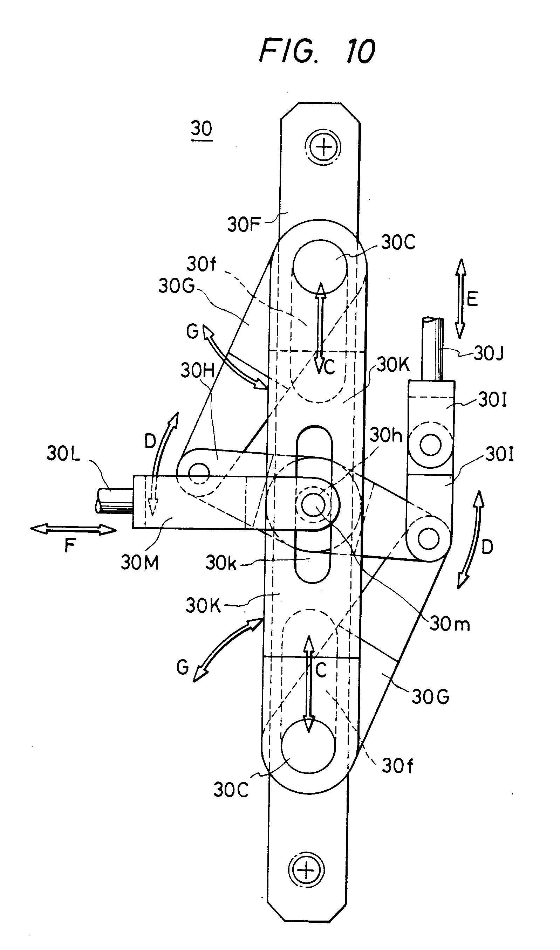

One end (or both ends) of the rotary shaft 30C is, as shown in Figs. 10 and 11 rotatably coupled to one end, of a moving arm member 30G through a guide slit 30f provided in a guide member 30F. The guide member 30F is fixed to the apparatus body with machine screws and the like (not shown) . The guide slit 30f extends in the direction of arrows C (Fig. 10) so as to guide the rotary shaft 30C and thereby the projecting press members 30A.

The other end of each moving arm member 30G is rotatably secured to one of the opposite ends of a rotary arm member 30H secured rotatably on a rotary shaft 30h in the direction of arrows D. The rotary arm member 30H is capable of moving each moving arm member 30G in the longitudinal direction of the arrows C.

The guide member 30F, the moving arm member 30G and the rotary arm member 30H for guiding the rotary shaft 30C constitute a link mechanism of the pressing mechanism 30 for mutually nearing and departing the projecting press members 30A installed on both sides of the printed circuit board 1 through the movement of the shaft 30J of a driving source for both surface use in the direction of arrow E. The shaft 30J is coupled to one end of the rotary arm member 30H through an arm coupling member 30I. The members constituting the link mechanism each are prepared from material relatively hardly deformable against external force such as iron, aluminum alloy and rigid plastics. The driving power may be derived from a pneumatic or hydraulic cylinder, or a solenoid. The shaft 30J may be coupled to one end of the moving arm member 30G through the arm coupling member 30I but not limited to one end of the rotary arm member 30H. The link mechanism is capable of driving the projecting press members 30A of both sides by means of a single driving source.

The guide member 30F, the moving arm members 30G and the rotary arm member 30H constituting the link mechanism are rigid bodies and the operating range of each is defined by the guide slit 30f and the rotary shaft 30h. In consequence, the projecting press members 30A on both sides of the printed circuit board 1 can be controlled accurately and equally in terms of their operating quantity and time.

Such link mechanism for coupling the projected press, members 30A and the driving source for both side use is simpler in construction than one formed with a rack and pinion or gear mechanism because the number of parts is smaller and each part is simpler in configuration.

At one end (or both ends) of each rotary shaft 30C linked with the moving arm member 30G is installed a press member rotating arm member 30K whose one end is fixed. At the other end of each press member rotating arm member 30K is provided a slit 30k and the shaft 30m of all arm coupling member 30M connected to a shaft 30L of the driving source for both side use is passed through the slit 30k. In other words, the press member rotating arm member 30K is coupled to the shaft 30L of the driving source for both side use through the coupling arm member 30M. As the driving source for both side use, a link mechanism similar to what has mentioned above may be used.

The press member rotating arm member 30K and the arm coupling member 30M constitute a projecting press member pressing mechanism of the pressing mechanism 30 for rotating the press member rotating arm member 30K in the direction of the arrow G as the shaft 30L moves in the direction of arrow F, rotating the rotary shaft 30C in the direction of arrow H (Fig. 11) and pressing the end of the laminated body.

The projecting press member pressing mechanism thus constructed is capable of operating the projecting press members 30A on both sides of the printed circuit board 1 with one driving source as in the case of the link mechanism for the projecting press members 30A, and controlling the operating quantity and time thereof accurately.

Moreover, the projecting press member pressing mechanism thus far described simplifies the coupling mechanism for coupling the projecting press members 30A and the driving source.

Referring to Figs. 9 through 14, the operation of the pressing mechanism 30 will now be briefly described;

A film end detector (not shown) is used to detect arrival of the laminated body on a board 1. As the film end detector, use can be made of a touch sensor for electrically detecting the end of the laminated body or a photosensor for detecting the same optically.

When the end of the laminated body stuck onto the printed circuit board has been detected by the film end detector, pinch roller 3A shown in Fig. 9 is pressed against the printed circuit board 1 using a press means (not shown) and the conveyance of the printed circuit board 1 is temporarily stopped by the press means and a conveyance driving roller 2. Material such as rubber having a high coefficient of friction is attached to the outer peripheral surface of the conveyance driving roller 2 to prevent the position of the printed circuit board from shifting, and the printed circuit board 1 is fixed by securely stopping its conveyance.

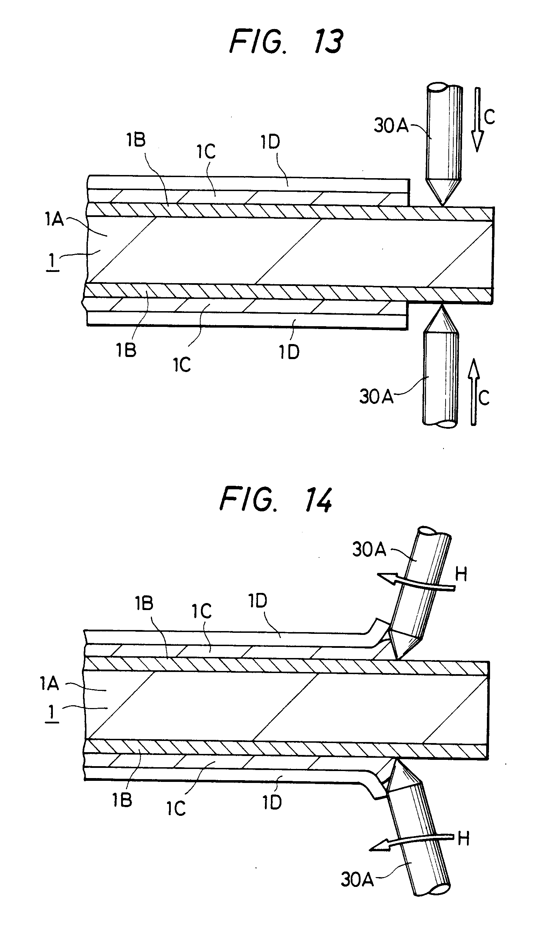

The shaft 30J of the driving source coupled to the link mechanism is moved in the direction of arrow E (upward in FIG. 10). This operation allows the link mechanism constituted by the rotary arm member 30H, the moving arm member 30G and the guide member 30F to operate and the rotary shaft 30C is caused to move in the direction of the arrow C. As the rotary shaft 30C moves, each of the front ends of the projected press members 30A on both sides of the printed circuit board 1 contacts the surface of the conductive layer 1B at the end of the laminated body as shown in Fig. 13. This contact is attained by the application of suitable force so that the elastic member 30D (30E) may have energy.

While the projecting press member 30A are in contact with the conductive layer 1B, the shaft 30L of the driving source coupled to the projecting press member pressing mechanism is operated (to the left in the drawing). This operation causes the projecting press member pressing mechanism composed of the projecting press member rotating arm member 30K and the arm coupling member 30M to operate and the rotary shaft 30C is rotated in the direction of the arrow H. As the rotary shaft 30C rotates, the front ends of the projecting press members 30A on both sides of the printed circuit board 1 press the end of the laminated body.

By pressing the end of the laminated body composed of the photosensitive resin layer 1C and the translucent resin film 1D and stuck on the printed circuit board 1 with the projecting press members 30A of the pressing mechanism 30, part of the translucent resin film 1D is peeled off the photosensitive resin layer 1C, so that a gap is produced in the interface. The gap is attributed to the fact that, because the photosensitive resin layer 1C is prepared from material softer than that for the translucent resin film 1D, the former is subjected to plastic deformation by the pressure applied by the projecting press member 30A, whereas the adhesion of the layer 1D to the layer 1C reduces before the latter is subjected to plastic deformation. The end of the translucent resin film 1D can thus be peeled off by the needle-shaped projecting press members 30A simple in configuration. Since the projecting press members 30A are installed in the conveyance path of the printed circuit board, the end of the translucent resin film 1D can automatically be peeled off. The translucent resin film 1D thus peeled off does not stick to the photosensitive resin layer 1C again unless it is heated and adhesion bonded under pressure.

A plurality of projecting press members 30A are installed in the direction across the conveyance direction of the printed circuit board 1 in this embodiment in consideration of the case that the laminated body may be heat bonded distortedly on the printed circuit board 1. However, the present invention is not restricted to the, above application. The pressing mechanism 30 may also have projecting press members 30A on both sides of the printed circuit board 1 as long as the ends of the photosensitive resin layers 1C and the translucent resin films 1D are pressed to ensure that the latter is peeled off.

Also, though arranged in the direction across the conveyance direction of the printed circuit boards 1, the projecting press members 30A may be installed at the end or any place close to the corner of the laminated body, seen in the conveyance direction of the printed circuit board 1. In this case, the nozzle 40A of a fluid spray mechanism 40 is set close to the projecting press members 30A.

The link mechanism of this embodiment is in the form of the projecting press member pressing mechanism of the pressing mechanism 30. However, the construction of the projecting press member pressing mechanism according to the present invention may also be arranged to carry the printed circuit board 1 slightly by rotating the conveyance driving roller 2 (or the pinch roller) so that the projecting press members 30A make contact with the surface of the printed circuit board 1 at the end of the laminated body and to press the end of the laminated body.

Moreover, the cross section of the projecting press member supporting rotary shaft 30C, in the direction across the axis of the shaft, according to the present invention may be square in view of increasing the accuracy of processing the through-holes into which the holders 30B are fitted and facilitating the processing.

As shown in Fig. 9, the fluid spray mechanism 40 may be so arranged as to send a jet of pressurized fluid, such as air, inactive gas or water, out of the nozzle 40A directly into the gap between the photosensitive resin layer 1C and the peeled translucent resin film 1D. The fluid spray mechanism 40 is also positioned close to the pressing mechanism 30 so that the fluid can instantly be sent to the gap. The fluid spray mechanism 40 is provided with the nozzle 40A whose set angle is variable in the direction of arrow J. In other words, the fluid spray mechanism 40 sets its nozzle 40A as close to the above gap as possible at the time of spraying the fluid and moves the nozzle 40A back to the position where it is prevented from touching the printed circuit board 1.

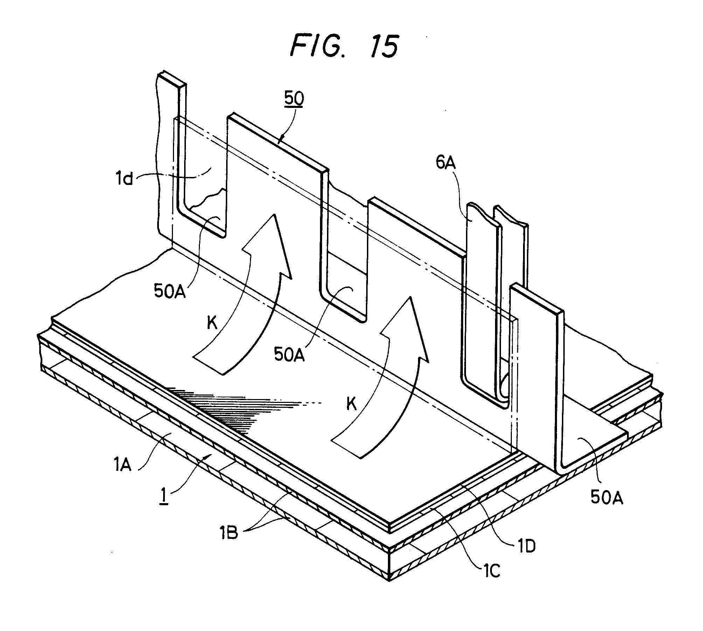

Since the fluid is blown into the gap between the photosensitve resin layer 1C and the translucent resin film 1D by means of the fluid spray mechanism 40 it is ensured that the translucent resin film 1D is peeled off the photosensitive resin layer 1C instantly. As shown in Figs. 9 and 15 (perspective view of the principal portion), the front end 1d of the translucent resin film 1D peeled off by the fluid spray mechanism 40 in the conveyance direction thereof adheres to the peel angle setting plate (auxiliary peeling plate) 50 under the fluid pressure, this plate allowing the setting of the peel position, direction and angle $\theta$. The peeled translucent resin film 1d is shown by an alternate long and short dash line in Figs. 9 and 15. The peel angle $\theta$ is the one existing between the translucent resin film stuck onto the printed circuit board 1 (or the printed circuit board 1 from which the translucent resin film 1D has been peeled) and the translucent resin film 1d pulled up, both of the layer and the film being at roughly right angles in this embodiment.

The front end of the peel angle setting plate 50 is installed apart from the translucent resin film 1D stuck on the printed circuit board 1 to an extent that it may not brush the resin film 1D to prevent damage to and breakdown of the photosensitive resin layer 1C. However, the front end of the peel angle setting plate 50 is movably arranged so as to tightly stick to the translucent resin film 1D during the fluid spray and prevent reduction of the peel effect. Moreover, the front end of the peel angle setting plate 50 is arcuate with a small curvature radius, e.g., a curvature radius of less than 3 mm.

The peel angle setting plate 50 has its front end located closer to the printed circuit board 1 than its portion adjacent the film delivery mechanism 6 and has a length equivalent to the width of the conveyance path of the printed circuit board 1 or the fluid spray width in the peel direction. In other words, the peel angle setting plate 50 is capable of increasing the peeling effect by preventing the fluid from being blown to its rear side. The direction of the fluid flow is shown by arrows K in Fig. 15.

The peel angle setting plate 50 is fixed in a predetermined position to the apparatus body apart from the nozzle 40A in the direction of the fluid flow. It is able to stabilize the peel position and exert uniform peeling force to the translucent resin film 1D. Accordingly, the peel angle setting plate 50 contributes to preventing the peel position from shifting while the translucent resin film 1D is being peeled off, further preventing peel stress from distorting, damaging or breaking the photosensitive resin layer 1C.

Principally the peel angle $\theta$ of the peel angle setting plate 50 may be variable within the range of obtuse to right angle with the translucent resin film 1D according to changes in conditions, e.g., material for the translucent resin film 1D, the fluid pressure in the fluid spray mechanism 40, etc. Moreover, the peel angle setting plate 50 may be made movable to deal with printed circuit boards 1 photosensitive resin layers 1C or translucent resin films 1D different in thickness. Adjustment thereof can be made by an air or hydraulic cylinder.

The translucent resin film 1d stuck to the peel angle setting plate 50 in the fluid spray mechanism 40 is, as shown in Figs. 9, sent out by the film delivery mechanism 6 after it has been peeled off.

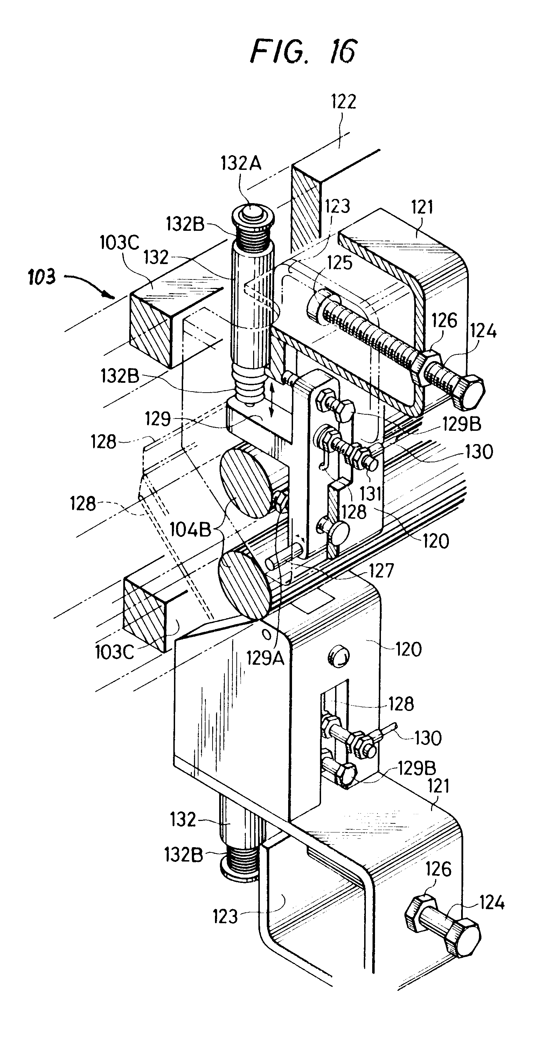

The film end detecting means 3 may advantageously be of an electric type. Fig. 16 shows an electrostatic capacitance type film end detector 3 (hereinafter referred to as a film end sensor). Reference numeral 120 denotes a cover which is mounted on a sensor position adjusting support member 121 provided on each of the upper and lower sides. The sensor position adjusting support member 121 is mounted on a support 123 attached to a sensor device body 122 through a sensor position adjusting bolt 124 and a sensor position adjusting nut 125 mounted on the support member 123. A sensor position fastening nut 126 is engaged with the sensor position adjusting bolt 124. A T-shaped support member 129 which is made of insulating material serves to support a contact sensor 128 through a rotary shaft 127. The T-shaped support member 129 is mounted through a screw 131 so that the contact sensor 128 may be electrically connected to a lead wire 130. The lead wire 130 is electrically connected to an electrostatic capacitance type end detector (not shown). Also, one end of the T-shaped support member 129 is pressed by an electromagnetic pressing means 132A so that it rotates about the rotary shaft 127. A contact sensor returning spring 129A for returning the contact sensor 128 attached to the T-shaped support member 129 is fixed to the cover 120 by screws. The T-shaped support member 129 is provided with a slant angle restricting stop 129B. Return springs 132B are provided at both ends of the movable member 132A of the electromagnetic pressing means 132. Reference character 103C denotes the rotary pressing member support shaft, and 104B denotes the rotary shaft of the fluid spray means.

Operation of the film end detecting sensors so far described is as follows:

First of all, the electromagnetic pressing means 132 is turned off to release depression of the movable member 132A against the T-shaped member 129 and to separate the contact sensor 129 from the surface of the board 1.

Next, the board 1 is moved to where the end of the protective film 1D on the board is at the set position of the contact sensor. The movement of the board 1 is stopped at this position. Under this condition, the electromagnetic pressing means 132 is turned on to depress the T-shpaed support member 129 with the movable member 132A and to bring the end of the contact sensor 128 into contact with the protective film 1D on board 1. Under this condition, the board 1 is moved in backward direction (opposite to the board travelling direction), thereby detecting the end of the protective film 1D and feeding its information to the electrostatic capacitance film end detector.

Also, simultaneously with the detection of the protective film 1D the forward/rearward operation of the conveyor is stopped while the pinch rollers are moved to fix the board 1. Under this condition, simultaneously with the fixture of the board 1, the electromagnetic pressing means 132 is turned off, the depression of the movable member 132A against the T-shaped member 129 is released, and the end of the contact sensor 128 is separated from the surface of the protecting film 1D on board 1. The pinch rollers are advantageously designed during the normal feeding operation to depress the board by their gravitational force.

Instead of the electromagnetic pressing means 132, any type of mechanisms such as pneumatic cylinders, hydraulic cylinders or the like could be used.

Also, instead of the film end detecting sensor so far described, optical means for detecting the quantity of the reflex light, the position of the light and the color of the reflex object could be used.

In case of optical means, the film end portion on the board 1 is advantageously moved twice past the set position of the photosensor in order to positively detect the film end under a stable condition. I.e. the end of the film may be detected by the first operation. However, in the case where the board 1 is thin, the film end is likely to be unstable, and there is a risk that the film end would not be detected. For this reason, by a second operation, the film end is detected while stabling the film end. The detection by the first operation is then confirmed by the second detecting operation.

Thus, according to the present invention, the film end of the travelling board 1 is detected by film end detecting means. An energy is applied by film lifting means to a portion from the film end defined by a predetermined distance from the film end, thereby lifting part of the film. In doing so, it is possible to obtain exact positional alignment between the detected film end and the film lifting means and to prevent damage of the pattern formed of resin on the board 1.

**Claims**

1. A film peeling apparatus for peeling and discharging a film (1D) stuck on a board (1), comprising:

    film end detecting means (Fig. 16) for detecting an end of the film (1D) while said board (1) is being conveyed through said apparatus, and

    film lifting means (3, 30) for lifting a part of an end portion of the film (1D) by applying a mechanical pressure to said part while the board (1) is being advanced in its conveying direction,

    **characterized** in that said film lifting means (3, 30) comprises a number of individual retractable pointed elements (23E$_2$, 30A) arranged in a row in a direction transverse to the conveying direction of the board (1).

2. The film peeling apparatus of claim 1, wherein said mechanical pressure is applied in a vibratory manner.

3. The film peeling apparatus of claim 2, wherein said film lifting means comprises an electromagnetic vibrator.

4. The film peeling apparatus of claim 2, wherein said film lifting means comprises a supersonic vibrator.

5. The film peeling apparatus of claim 2, wherein said film lifting means comprises a mechanical vibrator.

6. The film peeling apparatus of claim 2, wherein siad film lifting means comprises a hydraulic vibrator.

7. The film peeling apparatus of anyone of the preceding claims, wherein said pointed elements (23E$_2$, 30A) are or can be inclined with respect to a normal direction to said board (1).

8. The film peeling apparatus of anyone of the preceding claims, wherein the tip of said pointed elements (23E$_2$, 30A) is conical.

9. The film peeling apparatus of anyone of the preceding claims, wherein said board (1) is conveyed reciprocatingly thus that it passes said film end detecting means (Fig. 16) twice.

10. The film peeling apparatus of claim 9, wherein said film end detecting means (Fig. 16) detects said end of the film (1D) during the second pass of the board (1).

**Revendications**

1. Dispositif de pelage de film pour peler et décharger un film (1D) collé sur une plaquette (1), comprenant :

   un moyen de détection d'extrémité de film (figure 16) pour détecter une extrémité du film (1D) tandis que ladite plaquette (1) est convoyée au travers dudit dispositif ; et un moyen de soulèvement de film (3, 30) pour soulever une section d'une partie d'extrémité du film (1D) par l'application d'une pression mécanique à ladite section tandis que la plaquette (1) est avancée suivant sa direction de convoyage,

   caractérisé en ce que ledit moyen de soulèvement de film (3, 30) comprend un certain nombre d'éléments en forme de pointe individuellement rétractables (23E2, 30A) agencés selon une rangée suivant une direction transversale à la direction de convoyage de la plaquette (1).

2. Dispositif de pelage de film selon la revendication 1, dans lequel ladite pression mécanique est appliquée selon une manière vibratoire.

3. Dispositif de pelage de film selon la revendication 2, dans lequel ledit moyen de soulèvement de film comprend un vibrateur électromagnétique.

4. Dispositif de pelage de' film selon la revendication 2, dans lequel ledit moyen de soulèvement de film comprend un vibrateur supersonique.

5. Dispositif de pelage de film selon la revendication 2, dans lequel ledit moyen de soulèvement de film comprend un vibrateur mécanique.

6. Dispositif de pelage de film selon la revendication 2, dans lequel ledit moyen de soulèvement de film comprend un vibrateur hydraulique.

7. Dispositif de pelage de film selon l'une quelconque des revendications précédentes, dans lequel lesdits éléments en forme de pointe (23E2, 30A) sont ou peuvent être inclinés par rapport à une direction perpendiculaire à ladite plaquette (1).

8. Dispositif de pelage de film selon l'une quelconque des revendications précédentes, dans lequel l'extrémité desdits éléments en forme de pointe (23E2, 30A) est conique.

9. Dispositif de pelage de film selon l'une quelconque des revendications précédentes dans lequel ladite plaquette (1) est convoyée selon un mouvement alterné et ainsi, elle passe

   ledit moyen de détection d'extrémité de film (figure 16) deux fois.

10. Dispositif de pelage de film selon la revendication 9, dans lequel ledit moyen de détection d'extrémité de film (figure 16) détecte ladite extrémité du film (1D) pendant le second passage de la plaquette (1).

**Patentansprüche**

1. Film-Abziehvorrichtung zum Abziehen und Entsorgen eines Filmes (1D), der auf einer Platine (1) klebend haftet, mit:
   - einer Einrichtung (Fig. 16) zur Aufnahme eines Endes des Filmes (1D) während die Platine (1) durch die Vorrichtung geführt wird; und
   - Einrichtungen (3, 30) zum Abheben eines Teils eines Endes des Filmes (1D) durch Anwendung eines mechanischen Drukkes auf diesen Teil während die Platine (1) in ihrer Förderrichtung bewegt wird,

   **dadurch gekennzeichnet,** daß die Einrichtungen (3, 30) zum Abheben des Filmes eine Vielzahl von einzelnen, einziehbaren, spitzen Elementen (23E2, 30A) aufweisen, die in einer Reihe quer zur Förderrichtung der Platine (1) angeordnet sind.

2. Film-Abziehvorrichtung nach Anspruch 1, in der der mechanische Druck in einer vibrierenden Weise angewendet wird.

3. Film-Abziehvorrichtung nach Anspruch 2, in der die Film-Anhebeinrichtungen einen elektromagnetischen Vibrator beinhalten.

4. Film-Abziehvorrichtung nach Anspruch 2, in der die Film-Anhebeinrichtung einen superschall-Vibrator beinhaltet.

5. Film-Abziehvorrichtung nach Anspruch 2, in der die Film-Anhebeinrichtung einen mechanischen Vibrator beinhaltet.

6. Film-Abziehvorrichtung nach Anspruch 2, in der die Film-Anhebeinrichtung einen hydraulischen Vibrator beinhaltet.

7. Film-Abziehvorrichtung nach einem der vorangegangenen Ansprüche` in der die spitzen Elemente (23E2, 30A) in bezug auf die normale Richtung zu der Platine (1) geneigt sind oder sein können.

8. Film-Abziehvorrichtung nach einem der vorangegangenen Ansprüche, in der das obere Ende der spitzen Elemente (23E2, 30A) konisch ist.

9. Film-Abziehvorrichtung nach einem der vorangegangenen Ansprüche, in der die Platine (1) hin und her bewegt wird, so daß sie die Filmende-aufnehmende Einrichtung (Fig. 16) zweimal durchläuft.

10. Film-Abziehvorrichtung nach Anspruch 9, in der die Filmende-aufnehmende Einrichtung (Fig. 16) das Ende des Filmes (1D) während des zweiten Durchgangs der Platine (1) aufnimmt.

FIG. 1

# FIG. 2

## FIG. 3(A)

23E5    23E4    23E    23E3    23E2

## FIG. 3(B)

23E5    23E4    23E    23E3    23E1    23E2

## FIG. 4

23B    23C1    23C

23E2

23B    23C1

## FIG. 5

20

21    23    21    23    21    23    21    23    21    23    21    23    21    23    21

# FIG. 6

# FIG. 7

# FIG. 8

EP 0 223 198 B1

## FIG. 9

16

# FIG. 10

FIG. 12

FIG. 11

18

## FIG. 13

## FIG. 14

FIG. 15

# FIG. 16